# EUROPEAN PATENT APPLICATION

(11) **EP 4 832 057 A1**
(43) Date of publication of application: **28.10.2026**
(21) Application number: 24907283.6
(22) Date of filing: 11.12.2024
(51) Int. Cl.: H01L 23/13, C04B 37/02, H01L 23/12, H05K 1/02

(54) **CERAMIC CIRCUIT BOARD AND MANUFACTURING METHOD THEREFOR**

(30) Priority: 22.12.2023 JP 2023217066
(71) Applicant: Niterra Materials Co., Ltd., Kanagawa 235-0032 (JP)
(72) Inventor: UENO, Toshihide, Yokohama-shi, Kanagawa 235-0032 (JP); HASEGAWA, Koji, Yokohama-shi, Kanagawa 235-0032 (JP)
(74) Representative: Hoffmann Eitle
(86) International application number: PCT/JP2024/043878
(87) International publication number: WO 2025/134898

(57) **Abstract**

A ceramic circuit board according to an embodiment includes a ceramic substrate having a first face, and a first metal plate bonded to the first face with a first bonding layer interposed. In any cross section perpendicular to the first face, the first metal plate satisfies conditions as follows. A ratio L_{b}/Lₜ between a width L_{b} [mm] of a bottom side and a width Lₜ [mm] of a top side is not less than 1.005 and not more than 1.050. A ratio L₁/L₂ between a maximum width L₁ [mm] and a minimum width L₂ [mm] in an intermediate portion located between the bottom side and a distance 0.4 to 0.6 times a thickness T of the metal plate is not less than 1.0 and not more than 1.010. The ratio L_{b}/Lₜ is larger than the ratio L₁/L₂. The width L_{b} is longer than the minimum width L₁.

## Description

### [Technical Field]

Embodiments described herein relate generally to a ceramic circuit board and a manufacturing method therefor.

### [Background Art]

Ceramic substrates have excellent electrical insulation, heat resistance, and mechanical strength. Copper has excellent thermal conductivity and electrical conductivity. As circuit boards for power modules, ceramic circuit boards in which a metal plate made of, for example, copper is bonded to a ceramic substrate are widely used. The characteristics of ceramic circuit boards are the key to attain high power of power modules.

The main characteristics required for ceramic circuit boards include heat dissipation and durability in thermal cycle tests (TCTs). Here, the durability in thermal cycles is also referred to as TCT characteristics. As a larger current flows through a semiconductor element included in a power module, heat generation of the semiconductor element increases. With the improvement in heat dissipation and TCT characteristics, a larger current is allowed to flow through semiconductor elements, and semiconductor elements generating larger heat can be supported.

When the temperature of a ceramic circuit board changes, thermal stress is generated due to the difference between the coefficient of thermal expansion of the ceramic substrate and the coefficient of thermal expansion of the metal plate circuit. This thermal stress causes, for example, warping of the ceramic circuit board, or peeling or cracking of the metal plate. These cause degradation of insulation withstand voltage. Therefore, ceramic circuit boards are required to have high thermal-cycle durability in high-power use environments.

As one way to improve the heat dissipation of ceramic circuit boards, a method of increasing the thickness of the metal plate is used. As one way to increase thermal-cycle durability, a method of bonding a ceramic substrate and a metal plate with a bonding layer interposed to provide around the bonding layer and on the side face of the metal plate, a structure that contributes to reduction in thermal stress is used.

For example, International Publication No. WO2018/021472 (Patent Literature 1) proposes a technique of giving an inclined shape (skirt shape) on the side face of the metal plate (copper plate). The side face of the metal plate is in contact with the bonding layer at an angle of 40 degrees to 84 degrees. International Publication No. WO2015/019602 (Patent Literature 2) proposes a ceramic circuit board in which the metal plate (copper plate) has a thickness of not less than 1.0 mm and not more than 7.0 mm and the bonding layer has a predetermined protruding amount and a predetermined creeping-up amount.

Generally, when metal plates are made thicker, the allowable current amount and heat dissipation are improved. However, stress at the time of temperature change increases, and thermal-cycle durability is compromised. There has been a case where the stress may be unable to be sufficiently reduced only with the structure including the protruding portion and the creeping-up portion of the bonding layer. Further, in order to provide the structure, such as the skirt shape, on the side face of the metal plate as in Patent Literature 1, an etching process has been necessary. In the case of using the etching process, it has been difficult to use a thick metal plate because of costs, environmental loads, etc. In a circuit board having a large creeping-up amount as in Patent Literature 2, it is necessary to increase the distance between circuit patterns. When the distance between patterns increases, the number of circuits provided on the ceramic substrate decreases, which leads to a decrease in circuit density.

### [Prior Art Documents]

### [Patent Literature]

[Patent Literature 1] International Publication No. WO2018/021472
[Patent Literature 2] International Publication No. WO2015/019602

### [Summary of Invention]

### [Problem to be Solved by the Invention]

The invention provides a circuit board having excellent heat dissipation and high thermal-cycle reliability even in a case of including a thick metal plate, and a manufacturing method therefor.

### [Means for Solving the Problem]

A ceramic circuit board according to an embodiment includes a ceramic substrate having a first face, and a first metal plate bonded to the first face with a first bonding layer interposed. In any cross section perpendicular to the first face, the first metal plate satisfies conditions as follows. A ratio L_{b}/Lₜ between a width L_{b} [mm] of a bottom side and a width Lₜ [mm] of a top side is not less than 1.005 and not more than 1.050. A ratio L₁/L₂ between a maximum width L₁ [mm] and a minimum width L₂ [mm] in an intermediate portion located between the bottom side and a distance 0.4 to 0.6 times a thickness T of the metal plate is not less than 1.0 and not more than 1.010. The ratio L_{b}/Lₜ is larger than the ratio L₁/L₂. The width L_{b} is longer than the minimum width L₁.

### [Brief Description of Drawings]

[FIG. 1] FIG. 1A and FIG. 1B are schematic cross-sectional views showing an example configuration of a ceramic circuit board according to an embodiment.
[FIG. 2] FIG. 2 is a schematic cross-sectional view showing an example structure of a side-face shape of a metal plate and a bonding layer.
[FIG. 3] FIG. 3 is a schematic cross-sectional view showing an example configuration of the ceramic circuit board according to the embodiment.
[FIG. 4] FIG. 4 is a schematic cross-sectional view showing an example configuration of the ceramic circuit board according to the embodiment.
[FIG. 5] FIG. 5 is a flowchart showing a manufacturing method for the ceramic circuit board according to the embodiment.

### [Description of Embodiments]

A ceramic circuit board according to an embodiment includes a ceramic substrate having a first face, and a first metal plate bonded to the first face with a first bonding layer interposed. In any cross section perpendicular to the first face, the first metal plate satisfies conditions as follows. A ratio L_{b}/Lₜ between a width L_{b} [mm] of a bottom side and a width Lₜ [mm] of a top side is not less than 1.005 and not more than 1.050. A ratio L₁/L₂ between a maximum width L₁ [mm] and a minimum width L₂ [mm] in an intermediate portion located between the bottom side and a distance 0.4 to 0.6 times a thickness T of the metal plate is not less than 1.0 and not more than 1.010. The ratio L_{b}/Lₜ is larger than the ratio L₁/L₂. The width L_{b} is longer than the minimum width L₁.

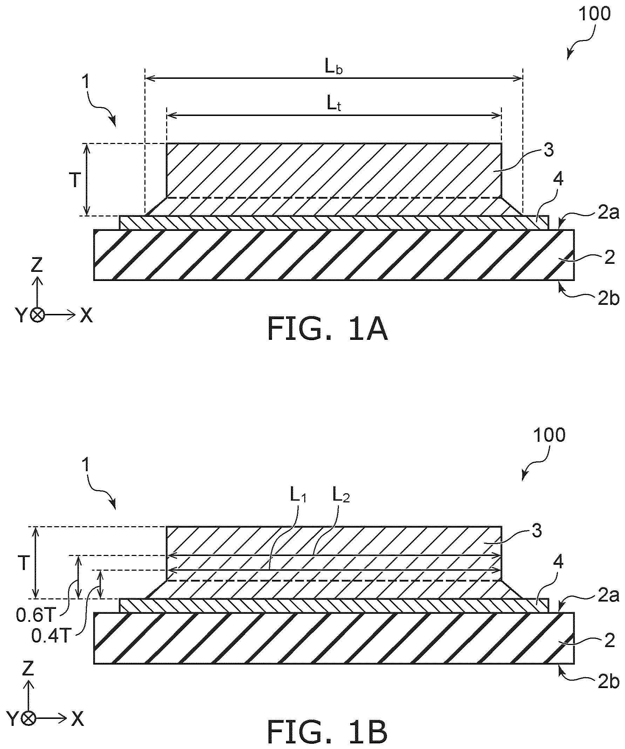

Hereinafter, a ceramic circuit board according to an embodiment and a manufacturing method therefor will be described with reference to the drawings. FIG. 1A and FIG. 1B are schematic cross-sectional views showing an example configuration of a ceramic circuit board according to an embodiment. Reference numeral 1 indicates a ceramic circuit board, reference numeral 2 indicates a ceramic substrate, reference numeral 3 indicates a metal plate, and reference numeral 4 indicates a bonding layer. Reference numeral T indicates the thickness of the metal plate, reference numeral Lₜ indicates the width of the top side of the metal plate, and reference numeral L_{b} indicates the width of the bottom side of the metal plate. Reference numeral L₁ indicates the maximum width in an intermediate portion of the metal plate. Reference numeral L₂ indicates the minimum width in the intermediate portion. The intermediate portion is a portion of the metal plate 3 located between the bottom side and a distance 0.4 to 0.6 times the thickness T of the metal plate.

The ceramic circuit board 1 shown in FIG. 1A and FIG. 1B includes the ceramic substrate 2, the metal plate 3 (first metal plate), and the bonding layer 4. The ceramic substrate 2 has a first face 2a and a second face 2b opposite to the first face 2a. The metal plate 3 is provided on the first face 2a of the ceramic substrate 2. The bonding layer 4 bonds the ceramic substrate 2 and the metal plate 3 together. FIG. 1A and FIG. 1B illustrate the ceramic circuit board 1 viewed from the same direction for the purpose of showing the reference numerals.

Here, the first face 2a and the second face 2b of the ceramic substrate 2 are also referred to as "front face" and "back face", respectively. For example, the shape of the ceramic substrate 2 when viewed from the front face is a quadrangular shape. The planar shape of the ceramic substrate 2 may be, for example, a circular shape (including an elliptic shape), a triangular shape, an L-shape, or a U-shape.

The ceramic substrate 2 is, for example, a silicon nitride substrate, an aluminum nitride substrate, a silicon oxide substrate, a silicon carbide substrate, an aluminum oxide substrate, a zirconium oxide substrate, or an alumina zirconia substrate. A silicon nitride substrate is preferable because of its excellent mechanical strength.

It is preferable that the thermal conductivity of the silicon nitride substrate be 70 W/m·K or more and the three-point bending strength thereof be 600 MPa or more. When the thermal conductivity and the three-point bending strength are within the above-described ranges, a silicon nitride substrate excellent in both heat dissipation and thermal-cycle durability is obtained.

The metal plate 3 is provided on at least one of the faces of the ceramic substrate 2. The metal plate 3 is mainly used as a circuit board or a heat sink, but may be used for other purposes. The type of the metal plate 3 is not specifically limited. For example, the metal plate 3 made of copper or a copper alloy is preferable in terms of conductivity and heat dissipation.

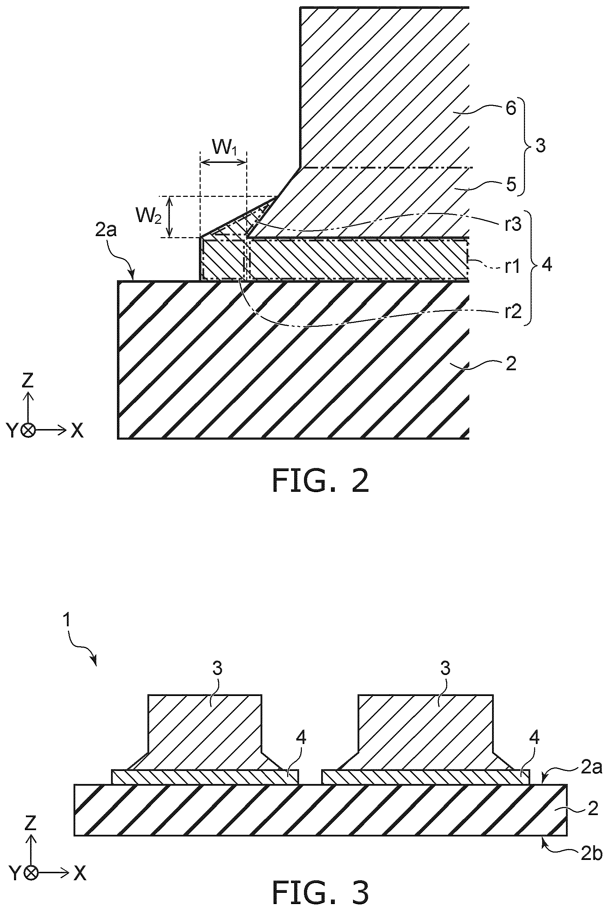

FIG. 2 is a schematic cross-sectional view showing an example structure of the side-face shape of the metal plate and the bonding layer. In FIG. 2, reference numeral 5 indicates a first portion, and reference numeral 6 indicates a second portion. Description of reference numerals common to FIG. 1 will be omitted.

Here, the direction perpendicular to the first face 2a is defined as a Z-direction. Any direction parallel to the first face 2a is defined as an X-direction. The direction perpendicular to the X-direction and the Z-direction is defined as a Y-direction.

As shown in FIG. 2, the metal plate 3 includes the first portion 5. The first portion 5 is located in the lower portion of the metal plate 3. The side face of the first portion 5 is inclined with respect to the Z-direction. In the first portion 5, the width of the metal plate 3 increases toward the bonding layer 4. The "width" is a length in one direction parallel to the first face 2a. The bottom face of the first portion 5 is in contact with the bonding layer 4.

As shown in FIG. 2, the metal plate 3 further includes the second portion 6. The second portion 6 is located on the first portion 5 and includes the upper portion and the intermediate portion of the metal plate 3. The inclination of the side face of the second portion 6 with respect to the Z-direction is smaller than the inclination of the side face of the first portion 5 with respect to the Z-direction. The inclination of the side face of the second portion 6 with respect to the Z-direction is within a range of 90° ± 5°. The side face of the second portion 6 may be parallel to the Z-direction.

The first portion 5 and the second portion 6 are a part of the metal plate 3 that is a single metal plate. In other words, the metal plate 3 is not a bonded metal plate obtained by bonding a metal plate corresponding to the first portion 5 and a metal plate corresponding to the second portion 6 together. For example, in the metal plate 3 that is a single metal plate, a portion having a shape that widens toward the bonding layer 4 is "first portion 5", and a portion whose side face is substantially perpendicular to the bonded face is "second portion 6". The upper end of the side face may be, for example, slightly chamfered, round-chamfered, or chamfered.

In FIG. 2, reference numeral r1 indicates a first region, reference numeral r2 indicates a second region, and reference numeral r3 indicates a third region. As shown in FIG. 2, the bonding layer 4 includes the first region r1, the second region r2, and the third region r3. The first region r1 is provided between the ceramic substrate 2 and the metal plate 3 in the Z-direction. The second region r2 is provided around the first region r1 along the first face 2a. The second region r2 protrudes outside the metal plate 3. In other words, when viewed from the Z-direction, the first region r1 overlaps the metal plate 3, and the second region r2 does not overlap the metal plate 3. The third region r3 is located on the second region r2 and is provided on the side face of the metal plate 3. For example, the third region r3 is provided on the side face of the first portion 5. The third region r3 may be further provided on the side face of the second portion 6. The third region r3 may be in contact with the side face of the metal plate 3.

In FIG. 2, reference numeral W₁ indicates the length of the second region r2 in a direction from the first region r1 toward the second region r2. Reference numeral W₂ indicates the length of the third region r3 in the Z-direction. Here, reference numeral W₁ is referred to as "protruding amount" and reference numeral W₂ is referred to as "rising amount".

In the ceramic circuit board according to the embodiment, the metal plate 3 has the following shape in any longitudinal section along the Z-direction.

First, the ratio L_{b}/Lₜ between the width L_{b} [mm] of the bottom side and the width Lₜ [mm] of the top side is not less than 1.005 and not more than 1.050. The bottom side is a side located at the bottom of the metal plate 3 in the longitudinal section. The width of the first portion 5 increases toward the bonding layer 4. Therefore, in the metal plate 3, the bottom side has the longest length in one direction parallel to the first face 2a of the ceramic substrate 2. The width L_{b} of the bottom side is the length of the widest part in the longitudinal section of the metal plate 3. The width L_{b} is also the width of the part that is in contact with the bonding layer 4.

The top side is a side located at the uppermost portion of the metal plate 3 in the longitudinal section. The width Lₜ of the top side is the length of the narrowest part in the longitudinal section. The lengths of the width L_{b} of the bottom side and the width Lₜ of the top side are measured in one longitudinal section in the direction parallel to the first face 2a of the ceramic substrate 2.

When the ratio L_{b}/Lₜ is within a range of not less than 1.005 and not more than 1.050, it indicates that the width of the bottom side of the metal plate 3 is longer than the width of the top side thereof. The ratio L_{b}/Lₜ is preferably not less than 1.010 and not more than 1.050.

Second, in the longitudinal section, the ratio L₁/L₂ between the maximum width L₁ [mm] and the minimum width L₂ [mm] in the intermediate portion is not less than 1.0 and not more than 1.010. Here, the thickness of the metal plate 3 is denoted by T [mm]. The intermediate portion is a part of the metal plate 3 located between the bottom side and a distance 0.4 to 0.6 times the thickness T. The maximum width L₁ and the minimum width L₂ are measured in the longitudinal section in the direction parallel to the first face 2a. In the intermediate portion, the maximum length in the direction parallel to the first face 2a is the maximum width L₁, and the minimum length in the direction parallel to the first face 2a is the minimum width L₂. When the ratio L₁/L₂ is within a range of not less than 1.0 and not more than 1.010, it indicates that the difference between the maximum width L₁ and the minimum width L₂ is at most 1% or less. That is, it indicates that the side face of the metal plate 3 in the intermediate portion is substantially perpendicular to the Z-direction and that the metal plate 3 includes the second portion 6. The ratio L₁/L₂ is preferably not less than 1.0 and not more than 1.005.

Third, in the longitudinal section, the ratio L_{b}/Lₜ is larger than the ratio L₁/L₂. When the ratio L_{b}/Lₜ is larger than the ratio L₁/L₂, it indicates that the difference in width between the top side and the bottom side is larger than the difference in width in the intermediate portion.

Fourth, the width L_{b} of the bottom side is larger than the maximum width L₁ of the intermediate portion. When the width L_{b} is larger than the maximum width L₁, it indicates that the width of the metal plate 3 increases in a portion below the intermediate portion. That is, when ratio L_{b}/Lₜ > ratio L₁/L₂ and width L_{b} > maximum width L₁ are satisfied, it indicates that the metal plate 3 includes the first portion 5.

The width L_{b} of the bottom side, the width Lₜ of the top side, the maximum width L₁, and the minimum width L₂ are all measured in the same longitudinal section. The shape of the metal plate 3 satisfies the above-described conditions in any longitudinal section of the ceramic circuit board 1.

Preferably, the metal plate 3 has the above-described shape in a plurality of longitudinal sections. For example, the metal plate 3 has the above-described shape in both one longitudinal section and another longitudinal section perpendicular to the one longitudinal section. Most preferably, the metal plate 3 has the above-described shape in all longitudinal sections passing through the center of the metal plate 3 in the X-Y plane. The "center" is, for example, in plan view of the metal plate 3, a point for which the sum of the distances from each point on the outer edge is largest.

To measure the thickness T, the width L_{b} of the bottom side, the width Lₜ of the top side, the maximum width L₁, and the minimum width L₂ of the metal plate 3, an enlarged photograph of a longitudinal section observed with an optical microscope or a scanning electron microscope (SEM) is used. It is recommended to set the magnification to about six-fold magnification.

Instead of the above-described shape, the metal plate 3 may have the following shape. The following shape may be combined with the above-described shape. First, in any longitudinal section, a value obtained by dividing the difference between the maximum width L₁ and the minimum width L₂ in the intermediate portion of the metal plate 3 by a value 0.4 times the thickness T is 0.05 or less (including zero). That is, (L₁ - L₂)/0.4T ≤ 0.05 is satisfied. Second, the ratio L_{b}/Lₜ between the width L_{b} of the bottom side and the width Lₜ of the top side is within a range of not less than 1.005 and not more than 1.050. Preferably, in any longitudinal section, (L₁ - L₂)/0.4T is 0.04 or less (including zero), and the ratio L_{b}/Lₜ is within a range of not less than 1.010 and not more than 1.050. In addition, it is more preferable that (L₁ - L₂)/0.2T < (L_{b} - Lₜ)/T be satisfied. More preferably, L_{b} > L₁ is satisfied.

Instead of the above-described shape, the metal plate 3 may have the following shape. The following shape may be combined with the above-described shape. First, in any longitudinal section, a value obtained by dividing the difference between the maximum width L₁ and the minimum width L₂ in the intermediate portion of the metal plate 3 by a value 0.4 times the thickness T is 0.05 or less (including zero), or the difference between the maximum width L₁ and the minimum width L₂ is 100 µm or less (including zero). That is, (L₁ - L₂)/0.4T ≤ 0.05 or L₁ - L₂ ≤ 100 µm is satisfied. Both conditions of (L₁ - L₂)/0.4T ≤ 0.05 and L₁ - L₂ ≤ 100 µm may be satisfied. Second, in the same longitudinal section, the ratio L_{b}/Lₜ between the width L_{b} of the bottom side and the width Lₜ of the top side is within a range of not less than 1.005 and not more than 1.050. Preferably, in any longitudinal section, at least either (L₁ - L₂)/0.4T ≤ 0.04 or L₁ - L₂ ≤ 80 µm is satisfied, and the ratio L_{b}/Lₜ is within a range of not less than 1.010 and not more than 1.050. More preferably, (L₁ - L₂)/0.2T < (L_{b} - Lt)/T is further satisfied. In addition, L_{b} > L₁ is preferably satisfied.

When at least either (L₁ - L₂)/0.4T ≤ 0.05 or L₁ - L₂ ≤ 100 µm is satisfied, it indicates that the metal plate 3 includes the second portion 6 whose side face is substantially parallel to the Z-direction. (L₁ - L₂)/0.2T < (L_{b} - Lt)/T similarly indicates that the metal plate 3 includes the second portion 6 whose side face is substantially parallel to the Z-direction.

The thickness T of the metal plate 3 corresponds to the shortest distance between the bottom side and the top side of the metal plate in a longitudinal section in a case where the thickness of the ceramic substrate and the thickness of the bonding layer are constant. Typically, the thickness T approximately corresponds to the thickness of the metal plate 3 before bonding. Therefore, the thickness of the metal plate before bonding may be used as the thickness T for simplicity.

When the metal plate 3 is bonded, the component of the bonding layer 4 may diffuse into the metal plate 3. In this case, the distance from the tip of the first portion 5 to the top side of the metal plates 3 in the Z-direction in a longitudinal section may be used as the thickness T. The "tip of the first portion 5" is, in the bonding part between the metal plate 3 and the bonding layer 4, a part closest to the ceramic substrate 2.

The thickness of the metal plate 3 may differ from portion to portion. The thickness T of the metal plate 3 need not be constant in a cross section. For example, an indentation or a projection may be provided in the surface of the metal plate 3. In a case where an indentation or a projection is provided in the surface, the maximum thickness of the metal plate 3 that is a single metal plate is defined as the thickness T. For example, in a case where an indentation having a depth of 1 mm is provided in a copper plate having a thickness of 2 mm, the thickness T is 2 mm. In a case where a projection having a height of 0.5 mm is provided on a copper plate having a thickness of 2 mm, the thickness T is 2.5 mm.

Another metal plate may be bonded to the surface of the metal plate 3 including the first portion 5 and the second portion 6 and satisfying the above-described conditions. For example, another metal plate having an irregular structure may be bonded to the surface of the metal plate 3. In this case, the distance between the top side and the bottom side of the metal plate 3 that is a single metal plate is used as the thickness T.

As long as the width L_{b}, the width Lₜ, the maximum width L₁, and the minimum width L₂ satisfy the above-described relationships, a partial structure may be provided on the side face of the metal plate 3. For example, a structure other than the second portion 6 may be partially provided on the metal plate 3, and a part of the side face of the metal plate 3 need not be parallel to the Z-direction.

For example, in a case where the side face of the metal plate 3 can be approximated as a straight line, a curve, or a hyperbolic curve as a whole in any longitudinal section, an indentation or a projection, such as a depression, a slit, a protrusion, or a flange, may be provided in the side face of a portion above the intermediate portion or in the side face of the first portion 5. Even in this case, the width L_{b}, the width Lₜ, the maximum width L₁, and the minimum width L₂ need to satisfy the above-described relationships in any longitudinal section.

As will be described below, for example, conditions in a heat bonding process for the ceramic substrate and the metal plate are controlled to thereby bond the metal plate 3 so that the first portion 5 is included while the shape of the second portion 6 is maintained.

In the ceramic circuit board 1 according to the embodiment, since the metal plate 3 includes the first portion 5, thermal stress applied to the ceramic substrate at the time of temperature change can be reduced. Specifically, since the first portion 5 is provided in the metal plate 3, stress concentration at the bonded end portion of the metal plate 3 can be suppressed.

The side face of the first portion 5 is inclined with respect to the Z-direction, and the width of the first portion 5 increases toward the bonding layer 4. In other words, in the outer peripheral portion of the first portion 5, the thickness of the first portion 5 decreases toward the side. This inclined shape can reduce stress concentration.

Further, since the third region r3 is provided on the side face of the first portion 5, the effect of reducing stress concentration is further improved. Specifically, in a case where the third region r3 is provided, the effect of reducing stress for the metal plate having a thickness of 1.0 mm or more is increased. Stress concentration occurs in the side end portion of the first portion 5. At this time, if the metal plate is thick, the stress further increases due to thermal expansion of the side face of the metal plate. When the third region r3 is provided, the stress generated in the side end portion of the first portion 5 is dispersed not only into the first region r1 and the second region r2 but also into the third region r3. Accordingly, even in a case where a thick metal plate is provided, the stress caused by thermal expansion of the side face can be reduced.

As the thermal stress is reduced, the metal plate 3 that is thicker can be used. That is, according to the embodiment, thermal-cycle characteristics are improved, and heat dissipation can also be improved. Meanwhile, if the first portion 5 exceeds the above-described range (the width L_{b} exceeds a value 1.050 times the width Lₜ), the size of the metal plate 3 needs to be increased as will be described below, and the circuit density may decrease.

In addition, since the metal plate 3 includes the second portion 6, it is possible to increase the volume of the metal plate 3 to improve heat dissipation while attaining the effect of stress reduction by the first portion 5. For example, according to the embodiment, the volume of the metal plate 3 can be made larger than in a case where the side face of the metal plate 3 is uniformly inclined.

Further, the embodiment is suitable for a method for processing the metal plate 3 into a circuit shape without using etching. Therefore, restrictions on the thickness of the metal plate 3 arising from the viewpoints of costs, environmental loads, etc. of etching can be reduced.

Further, according to the embodiment, the area of the top face of the metal plate 3 can be increased, and a circuit design relating to, for example, mounting of semiconductor elements can be made more flexible. The accuracy of position detection using a CCD camera or the like can also be increased.

Since the second portion 6 is provided in the metal plate 3, the inter-pattern distance in the ceramic circuit board 1 can be decreased. The "inter-pattern distance" is, in a case where the side faces of the plurality of metal plates 3 face each other or in a case where the side faces of portions of one metal plate 3 face each other, the shortest distance between the second regions r2 protruding from the side faces. When the inter-pattern distance in the ceramic circuit board 1 is decreased, the circuit density can be increased. The inter-pattern distance in the ceramic circuit board 1 is preferably 0,4 mm or more. If the inter-pattern distance is less than 0.4 mm, current leakage between the patterns may occur.

For example, in a case where the metal plate 3 that is thick is given a circuit shape by etching, the side face of the metal plate 3 is inclined by the etching. Taking into consideration variations caused by the etching, as the metal plate 3 is thicker, the inter-pattern distance needs to be made longer. Further, in a case where the metal plate 3 is thick, if the side face is inclined, the size of the metal plate 3 in the X-Y plane increases in order to attain an area necessary for mounting semiconductor elements on the top face of the metal plate 3. Therefore, using etching for the thick metal plate 3 results in a decrease in the circuit density. According to the embodiment, the metal plate 3 includes the second portion 6 whose side face is substantially parallel to the Z-direction. In other words, in the ceramic circuit board 1 according to the embodiment, the circuit shape of the metal plate 3 is given by a method, such as pressing or wire cutting, other than etching. When the metal plate 3 is given a circuit shape by such a method, variations in the inter-pattern distance can be reduced and the inter-pattern distance can be made shorter. Further, even in a case where the metal plate 3 is thick, an increase in the size of the metal plate 3 in the X-Y plane can be suppressed and the circuit density can be increased.

According to the embodiment, the inter-pattern distance in the ceramic circuit board 1 can be set to, for example, 10 mm or less. The inter-pattern distance in the ceramic circuit board 1 may be 7 mm or less and may be 5 mm or less. Preferably, the inter-pattern distance in the ceramic circuit board 1 is not less than 0.4 mm and not more than 3 mm.

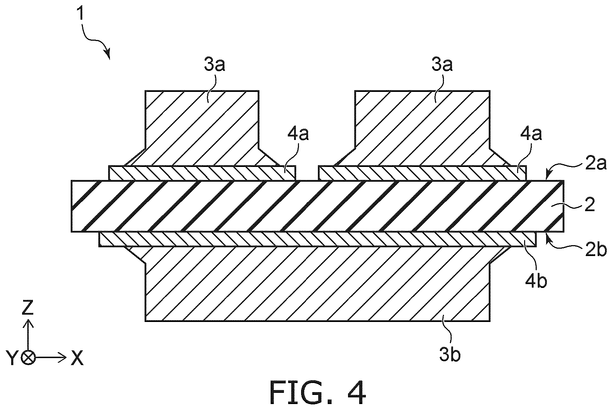

FIG. 3 and FIG. 4 are schematic cross-sectional views showing example configurations of the ceramic circuit board according to the embodiment. As shown in FIG. 3, in the ceramic circuit board 1, a plurality of metal plates 3 may be provided on one of the faces of the ceramic substrate 2 with a plurality of bonding layers 4 interposed respectively. Typically, one metal plate 3 is bonded to the ceramic substrate 2 with one bonding layer 4 interposed. When necessary, a plurality of metal plates 3 may be bonded to the ceramic substrate 2 with one bonding layer 4 interposed, or one metal plate 3 may be bonded to the ceramic substrate 2 with a plurality of bonding layers 4 interposed, the plurality of bonding layers 4 being separated from each other in the X-Y plane.

As shown in FIG. 4, the ceramic circuit board 1 may include a plurality of metal plates 3 (a metal plate 3a and a metal plate 3b). The metal plate 3a is bonded to the first face 2a of the ceramic substrate 2 with a bonding layer 4a (first bonding layer) interposed. The metal plate 3b (second metal plate) is bonded to the second face 2b of the ceramic substrate 2 with a bonding layer 4b (second bonding layer) interposed.

In the example shown in FIG. 4, two metal plates 3a are bonded to the first face 2a, and one metal plate 3b is bonded to the second face 2b. This example is not limiting, and three or more metal plates 3a may be bonded to the first face 2a, or a plurality of metal plates 3b may be bonded to the second face 2b as needed. In the example shown in FIG. 4, the metal plate 3b is used as a heat sink. The metal plate 3b that is used as a circuit may be bonded to the second face 2b.

In the examples shown in FIG. 3 and FIG. 4, regarding components the same as those of the ceramic circuit board 1 shown in FIGS. 1A and 1B and FIG. 2, the description of the ceramic circuit board 1 shown in FIGS. 1A and 1B and FIG. 2 is referred to as appropriate.

The thickness T of the metal plate 3 is desirably not less than 0.5 mm and not more than 10 mm. If the thickness of the metal plate 3 is less than 0.5 mm, sufficient heat dissipation performance might not be attained. If the thickness of the metal plate is more than 10 mm, the amount of deformation due to thermal expansion may become large, and thermal-cycle characteristics may be degraded. In a case where the thickness of the metal plate 3 differs from portion to portion, the minimum thickness and the maximum thickness of the metal plate 3 are desirably within a range of not less than 0.5 mm and not more than 10 mm.

In a case where the metal plate 3a and the metal plate 3b are respectively provided on the first face 2a and the second face 2b of the ceramic substrate 2 as shown in FIG. 4, it is preferable that the thickness of the metal plate 3a be not less than 0.5 mm and not more than 10 mm and the thickness of the metal plate 3b be not less than 0.5 mm and not more than 10 mm. It is more preferable that the thickness of the metal plate 3a be not less than 1.0 mm and not more than 6.0 mm and the thickness of the metal plate 3b be not less than 1.0 mm and not more than 6.0 mm. If the thicknesses of the metal plate 3a and the metal plate 3b are within the above-described ranges, thermal-cycle characteristics are improved.

In a case where a plurality of metal plates 3 are provided on the same plane, there may be a difference in thickness between the metal plates 3. The difference in thickness is not specifically limited, but is preferably 3.0 mm or less. When the width L_{b}, the width Lₜ, the maximum width L₁, and the minimum width L₂ satisfy the above-described relationships, thermal-cycle characteristics can be improved even in a case where there is a difference in thickness between the metal plates 3. In other words, if the difference in thickness between the metal plates 3 exceeds 3.0 mm, thermal-cycle characteristics may be degraded.

In a case where the metal plates 3 are provided on both faces of the ceramic substrate 2 as shown in FIG. 4, the ratio between the volume of the metal plate 3a and the volume of the metal plate 3b is not specifically limited, but may be not less than 0.98 and not more than 1.02. The volume ratio is calculated by using the total volume of one or more metal plates 3a provided on the first face 2a and the total volume of one or more metal plates 3b provided on the second face 2b. The volume ratio is calculated by dividing the total volume of the one or more metal plates 3a by the total volume of the one or more metal plates 3b. That is, the volume ratio is calculated by dividing the total volume of the front metal plates 3 by the total volume of the back metal plates 3. When the volume ratio is within a range of not less than 0.98 and not more than 1.02, the difference between a stress generated when the one or more metal plates 3a are thermally deformed and a stress generated when the one or more metal plates 3b are thermally deformed can be decreased. As a result, thermal-cycle characteristics can be improved.

Even in a case where the thickness of the metal plate 3 differs from portion to portion and the thickness T is not constant even in a longitudinal section, thermal-cycle characteristics can be improved by setting the volume ratio to within the above-described range. Even in a case where an indentation or a projection is provided in the surface of the metal plate 3 that is a single metal plate or in a case where another metal plate is bonded to the surface of the single metal plate, thermal-cycle characteristics can be improved.

The bonding layer 4 bonds the ceramic substrate 2 and the metal plate 3 together. The metal plate 3 is, for example, a copper plate (including a copper alloy plate) or an aluminum plate (including an aluminum alloy plate). For example, a paste of an active metal brazing filler containing Ti is applied to the ceramic substrate 2, and the metal plate 3 is disposed on the active metal brazing filler paste. When the ceramic substrate 2 and the metal plate 3 are heated, the ceramic substrate 2 and the metal plate 3 are bonded to each other. At this time, the active metal brazing filler paste melts and thereafter solidifies, and the bonding layer 4 is formed.

The active metal brazing filler preferably contains, for example, Ag in an amount of not less than 0 mass% and not more than 70 mass% or Cu in an amount of not less than 15 mass% and not more than 85 mass%, and Ti or TiH₂ in an amount of not less than 1 mass% and not more than 15 mass%. In a case where the active metal brazing filler contains both Ti and TiH₂, the total of Ti and TiH₂ is preferably within a range of not less than 1 mass% and not more than 15 mass%. In a case where the active metal brazing filler contains both Ag and Cu, it is preferable that the active metal brazing filler contains Ag in an amount of not less than 20 mass% and not more than 60 mass%, and Cu in an amount of not less than 15 mass% and not more than 40 mass%. The active metal brazing filler may contain one type or two types selected from among Sn and In in an amount of not less than 1 mass% and not more than 50 mass% as needed. The active metal brazing filler may contain C in an amount of not less than 0.1 mass% and not more than 2 wt% as needed.

Ag or Cu is a base material component of the brazing filler. Sn or In has an effect of lowering the melting point of the brazing filler. C (carbon) has an effect of controlling the fluidity of the brazing filler and an effect of controlling the composition of the bonding layer by reacting with other components. Instead of Sn or In, a low-melting-point metal, such as Bi, Sb, or Ga, may be used. If the composition of the active metal brazing filler is within the above-described ranges, the first portion 5 is formed in the metal plate 3 when heat bonding is performed under conditions described below.

The bonding layer 4 preferably includes a protruding portion (second region r2) protruding outside the metal plate 3 as shown in FIG. 2. When the bonding layer 4 includes the second region r2, it is possible to improve the bonding strength and to improve thermal-cycle characteristics.

The length of the second region r2 in the direction from the first region r1 toward the second region r2 is referred to as the protruding amount W₁. The protruding amount W₁ is measured with reference to a part of the outer peripheral edge of the bonding layer 4, the part being farthest from the end portion of the first portion 5 of the metal plate 3. The protruding amount W₁ is preferably not less than 0.1 mm and not more than 2 mm. If the protruding amount W₁ is less than 0.1 mm, reduction in stress during TCT cycles is likely to be insufficient. If the protruding amount W₁ exceeds 2 mm, a further effect of improving the bonding strength is less likely to be attained. The protruding amount W₁ is more preferably not less than 0.2 mm and not more than 0.7 mm. The protruding amount W₁ can be controlled by, for example, the composition of the active metal brazing filler and heat treatment conditions at the time of bonding.

The bonding layer 4 preferably includes the third region r3 provided on the side face of the metal plate 3 as shown in FIG. 2. When the bonding layer 4 includes the third region r3, it is possible to improve the bonding strength and to improve thermal-cycle characteristics.

The length of the third region r3 in the Z-direction is referred to as the rising amount W₂. As the rising amount W₂, the length of the bonding layer 4 that is in contact with the side face of the metal plate 3 is measured in the thickness direction of the metal plate 3 (Z-direction). The rising amount W₂ is preferably, for example, not less than 0.05 mm and not more than 5 mm. If the rising amount W₂ is less than 0.05 mm, an effect of stress reduction is likely to be insufficient. If the rising amount W₂ exceeds 5 mm, a further effect of improving the bonding strength is less likely to be attained. The upper limit of the rising amount W₂ is the thickness T of the metal plate 3. In other words, the rising amount W₂ is controlled within a range not exceeding the thickness T of the metal plate.

The bonding layer 4 needs to include the second region r2 and the third region r3 in any longitudinal section. Preferably, the second region r2 and the third region r3 are provided around the entire outer periphery of the bonding layer 4. In this case, it is preferable that the rising amount W₂ vary depending on the part because thermal stress is reduced. For example, in a case where the rising amount W₂ in each part of the outer periphery of the bonding layer 4 is measured, it is preferable that the difference between the maximum value of the rising amount W₂ and the minimum value of the rising amount W₂ be 0.1 mm or more. The rising amount W₂ can be controlled by, for example, the composition of the active metal brazing filler and heat treatment conditions at the time of bonding.

A manufacturing method for the ceramic circuit board 1 according to the embodiment will now be described. As long as the ceramic circuit board 1 satisfies the above-described configurations, the manufacturing method therefor is not specifically limited. Here, an example of an efficient manufacturing method for the circuit board will be described.

First, the ceramic substrate 2 is prepared. The ceramic substrate 2 is, for example, a silicon nitride substrate, an aluminum nitride substrate, a silicon oxide substrate, a silicon carbide substrate, an aluminum oxide substrate, a zirconium oxide substrate, or an alumina zirconia substrate, as described above. In a case where a silicon carbide substrate is used, an insulating film may be provided on the surface.

Next, a brazing filler paste for forming the bonding layer is prepared. As the brazing filler, a metal powder or a metal compound powder is used. The brazing filler is preferably, for example, an active metal brazing filler . The active metal brazing filler preferably contains titanium as an active metal. As the titanium, titanium hydride (TiH₂) may be used. Here, a titanium hydride powder is also included as one type of the metal powder.

In a case where the metal plate 3 is a copper plate, the active metal brazing filler preferably contains one of or both Ag (silver) and Cu (copper), and Ti (titanium). The active metal brazing filler preferably further contains one of or both Sn (tin) and In (indium). C (carbon) may be added to the active metal brazing filler. The percentages of the active metal element, Ag (silver), Cu (copper), Sn (tin), In (indium), and C (carbon) in the active metal brazing filler are as described above. A metal powder in which a material element is alloyed may be added.

In a case where the metal plate is an aluminum plate, the active metal brazing filler preferably contains Al (aluminum) and Si (silicon). In this case, Si is the active metal. For example, the active metal brazing filler contains Si in an amount of not less than 0.1 mass% and not more than 20 mass%, and aluminum as the remainder.

When a mixed powder obtained by mixing the metal powders is mixed with a binder and an organic solvent, the active metal brazing filler paste can be prepared. The average particle diameter of each metal powder is preferably not less than 1 µm and not more than 7 µm.

Next, the active metal brazing filler paste is applied onto the first face 2a of the ceramic substrate 2. The thickness of the application layer (brazing filler layer) of the active metal brazing filler paste is preferably not less than 5 µm and not more than 80 µm. The thickness of the application layer is a thickness after the applied paste is dried. If the thickness of the application layer is less than 5 µm, the bonding strength may be insufficient. In addition, a diffusion region of the brazing filler is less likely to be formed in the metal plate 3. If the thickness of the application layer exceeds 80 µm, thermal stress in a bonding process increases, and warping of the circuit board may increase. Further, characteristics including the bonding strength is less likely to be improved, and manufacturing costs increase. The thickness of the application layer is more preferably not less than 10 µm and not more than 50 µm.

Here, a method of applying a brazing filler paste to the ceramic substrate 2 to form a brazing filler layer has been described. As another method, a method of disposing a brazing filler foil is available.

Next, the metal plate 3 is disposed on the application layer. As the metal plate 3, a circuit board processed into a desired size by, for example, pressing or wire cutting may be used. When, for example, pressing or wire cutting is used, the shape of the metal plate 3 can be easily adjusted so as to include the second portion 6. The metal plate 3 may be processed in advance to prepare the metal plate 3 including the first portion 5 and the second portion 6. The metal plate 3 is, for example, a copper plate (including a copper alloy plate) or an aluminum plate (including an aluminum alloy plate).

A portion corresponding to the second region r2 and the third region r3 may be formed in advance in the application layer so that the bonding layer 4 after heat bonding includes the second region r2 and the third region r3. The brazing filler paste may be applied to the side face of the metal plate 3 after the metal plate 3 is disposed to form a portion corresponding to the second region r2 and the third region r3. When the metal plate 3 is disposed, pressure may be applied toward the application layer. When pressed by the metal plate 3, the application layer spreads toward the outer periphery, and a part of the application layer rises along the side face of the metal plate 3.

In the manufacturing method for the ceramic circuit board 1 according to the embodiment, the metal plate 3 in a predetermined circuit shape is disposed. In other words, it is not necessary to give the circuit shape by an etching process. When the third region r3 is formed in the bonding layer 4, it indicates that the circuit shape is not given by the etching process. That is, the ceramic circuit board 1 according to the embodiment is an etching-less product.

In a case where the metal plate 3 (back metal plate) is provided on the second face 2b of the ceramic substrate 2 or in a case where a plurality of metal plates 3 are provided on the first face 2a, these metal plates 3 are also disposed by processes similar to those described above.

Next, heat bonding is performed. The bonding temperature is preferably not less than 600°C and not more than 950°C. The "bonding temperature" refers to a maximum temperature reached during heating, and the stacked structure including the ceramic substrate 2 and the metal plate 3 is held at the bonding temperature for a predetermined time. If the bonding temperature is lower than 600°C, sufficient bonding reliability might not be attained. In a case where the first portion 5 is not formed in advance in the metal plate 3, the first portion 5 might not be formed in the metal plate 3. If the bonding temperature is higher than 950°C, excessive residual stress may be generated, and the reliability of the product may be degraded.

The melting point of copper is 1085°C, and the melting point of aluminum is 660°C. In a case of using a copper plate, the bonding temperature is preferably not less than 700°C and not more than 950°C, and more preferably not less than 750°C and not more than 930°C. In a case of using an aluminum plate, the bonding temperature is preferably not less than 600°C and not more than 700°C. In a case where the melting point of a metal plate to be used is lower than 700°C, heat bonding is preferably performed at a bonding temperature lower than the melting point of the metal plate.

In the heat bonding, the bonding temperature within the above-described ranges is preferably maintained for 15 minutes or more in order to sufficiently melt the brazing filler.

When the temperature is increased from 200°C to the bonding temperature in the heat bonding process, a temperature holding stage may be provided. The temperature holding stage refers to a stage of holding the stacked structure at a temperature lower than the bonding temperature. The time of the temperature holding stage is preferably not less than 10 minutes and not more than 4 hours. The holding temperature during the temperature holding stage is preferably within a range of not less than 400°C and not more than 900°C. When the temperature holding stage is provided in the temperature increase stage, the temperatures of the ceramic substrate 2, the brazing filler layer, and the metal plate 3 can be made uniform. After the temperature holding stage, the ceramic substrate 2, the brazing filler layer, and the metal plate 3 are heated up to the bonding temperature.

When the temperature is decreased from the bonding temperature to normal temperature after the heat bonding process, the temperature holding stage is preferably provided. In the temperature holding stage in the temperature decrease stage, the stacked structure is held at a temperature lower than the bonding temperature by not less than 10°C and not more than 150°C. The time of the temperature holding stage is preferably not less than 10 minutes and not more than 4 hours. When the temperature holding stage satisfying these conditions is provided in the temperature decrease stage, the inside of the stacked structure can be uniformly heated at a temperature around the solidification point of the brazing filler, and the bonding can be strengthened. In other words, it is preferable to use a brazing filler whose solidification point is at a temperature lower than the bonding temperature by 10°C to 150°C. Further, when the temperature in the stacked structure is made uniform, variations in the amount of thermal deformation can be suppressed. When the temperature in the furnace is made uniform, the bonding reliability can be improved.

In the heat bonding process, the metal plate 3 slightly expands at the bonding temperature. A portion of the metal plate 3, the portion being in contact with the bonding layer 4, also expands. When the temperature holding stage is provided in the temperature decrease stage, the portion of the metal plate 3, which is in contact with the bonding layer 4, is bonded in an expanded state. Further, in the temperature decrease stage, a portion of the metal plate 3 close to the top side contracts. Accordingly, the first portion 5 can be formed in the metal plate 3.

In view of the above, in order to form the first portion 5, it is preferable to provide the temperature holding stage described above when the temperature is decreased from the bonding temperature to normal temperature. In a case of bonding the ceramic substrate 2 and the metal plate 3 using a continuous furnace as will be described below, instead of providing the above-described temperature holding stage, it is preferable to perform cooling while blowing a nitrogen gas onto the bonded structure because a similar effect can be attained. When a nitrogen gas is blown, cooling of the portion of the metal plate 3 close to the top side proceeds. Accordingly, the ceramic substrate 2 and the metal plate 3 can be bonded together in a state in which the portion of the metal plate 3, which is in contact with the bonding layer, is expanded. The temperature holding stage in the temperature decrease stage and the cooling by blowing of a nitrogen gas may be combined.

The atmosphere during the heat bonding process is preferably a vacuum or a non-oxidizing atmosphere. The non-oxidizing atmosphere is, for example, a nitrogen atmosphere, an argon atmosphere, or a hydrogen atmosphere. The pressure in the vacuum is preferably 0.3 kPa or less, and more preferably 10⁻³ Pa or less. Ti in the brazing filler may be oxidized or nitrided by oxygen or nitrogen in the atmosphere before reacting with the ceramic substrate 2. When the heat bonding is performed in the vacuum, oxidation or nitriding of Ti before reaction with the ceramic substrate 2 can be suppressed.

The nitrogen atmosphere refers to an atmosphere containing nitrogen in an amount of not less than 90 vol% and not more than 100 vol% . If nitrogen is present in the atmosphere during the bonding process, Ti in the brazing filler can be nitrided by the nitrogen in the atmosphere before reacting with the ceramic substrate. However, if the Ti content in the brazing filler is 6 mass% or more, Ti in the brazing filler can sufficiently react with the ceramic substrate 2 even in the nitrogen atmosphere.

In a case where the ceramic substrate 2 and the metal plate 3 are bonded in a vacuum, a vacuum furnace is used. In a case where the ceramic substrate 2 and the metal plate 3 are bonded in a nitrogen atmosphere, a continuous furnace may be used.

In the heat bonding, a load may be applied to the stacked structure including the ceramic substrate 2, the active metal brazing filler, and the metal plate 3. It is preferable to fix the stacked structure with a jig and apply a load of 0.5 kPa or more to the stacked structure. The application of a load of 0.5 kPa or more facilitates close bonding of the bonded interface. Further, it facilitates forming of the first portion 5 in the metal plate 3. To apply the load, a member other than the jig may be used, or the weight of the jig may be used as the load.

When heat bonding is performed under the above-described conditions, the first portion 5 is formed in the metal plate 3 while the shape of the second portion 6 is maintained. By this method, the ceramic circuit board can be an etching-less product. Since etching is not necessary, costs and loads on the environment can be reduced.

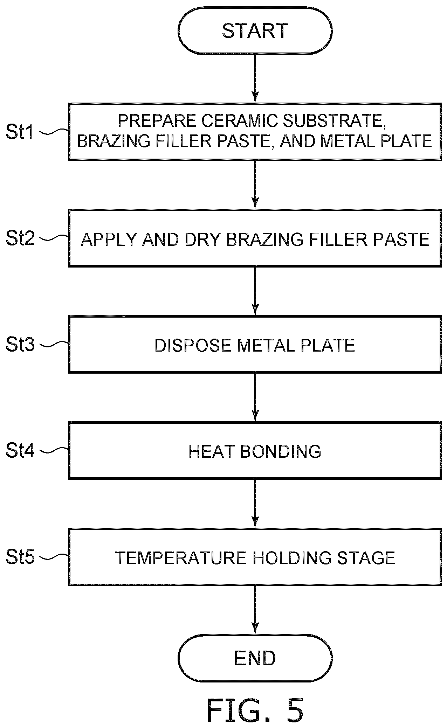

FIG. 5 is a flowchart showing the manufacturing method for the ceramic circuit board according to the embodiment. First, the ceramic substrate 2, an active metal brazing filler paste, and the metal plate 3 are prepared (step St1). The metal plate 3 is preferably processed in advance into a circuit shape by, for example, pressing or wire cutting. The active metal brazing filler paste is applied onto the ceramic substrate 2, and the paste is dried. (step St2). The metal plate 3 is disposed on the dried application layer (step St3). The stacked structure including the ceramic substrate 2, the active metal brazing filler, and the metal plate 3 is heated to bond the ceramic substrate 2 and the metal plate 3 together (step St4). The temperature holding stage may be provided in the temperature increase stage up to the bonding temperature. After the bonding, the temperature holding stage is performed during a temperature decrease (step St5). The ceramic circuit board 1 according to the embodiment is manufactured by the above-described processes.

Semiconductor elements are mounted on the ceramic circuit board 1 to thereby manufacture a semiconductor device. Wire bonding, a lead frame, and so on may be mounted on the semiconductor device as needed. Further, the semiconductor device may be subjected to resin molding as needed. In the resin molding, for example, a potting resin is used.

### (Examples)

Specific examples and their evaluation results will be described. In the examples, a silicon nitride substrate having a thermal conductivity of 90 W/m·K, a three-point bending strength of 700 MPa, and 30 mm in length, 50 mm in width, and 0.3 mm in thickness was prepared as a ceramic substrate.

An active metal brazing filler paste was produced and applied to the first face and the second face of the ceramic substrate. The compositions of active metal brazing filler pastes used are shown in Table 1. Table 1 shows values when the total of the metal components is 100 wt%.

**[Table 1]**

| | Composition [wt%] |
|---|---|
| Brazing filler 1 | Ag(70), Cu(28), TiH₂(2) |
| Brazing filler 2 | Ag(50), Cu(30), Sn(10), TiH₂(10) |
| Brazing filler 3 | Ag(15), Cu(60), In(12), TiH₂(12), C(1) |
| Brazing filler 4 | Cu(65), Sn(25), TiH₂(10) |

Next, a metal plate processed into a desired shape was prepared and disposed on the application layer of the active metal brazing filler paste. The types, thicknesses, and forms of metal plates used are shown in Table 2. The configuration of a ceramic substrate on which metal plates are disposed in each Example is shown in Table 3. In Table 3, a metal plate disposed on the first face of the ceramic substrate is shown as "front metal plate", and a metal plate disposed on the second face is shown as "back metal plate". Each metal plate was processed so as to include the second portion. For this processing, die pressing was suitable. Therefore, an etching process was not necessary, and no etching waste liquid was generated.

**[Table 2]**

| | Material | Thickness [mm] | Form |
|---|---|---|---|
| Metal plate 1 | Copper | 0.8 | Single |
| Metal plate 2 | Copper | 6.0 | Single |
| Metal plate 3 | Copper | 9.0 | Single |
| Metal plate 4 | Copper | 0.5, 0.5 | Multiple |
| Metal plate 5 | Copper | 2.5, 2.5 | Multiple |
| Metal plate 6 | Copper | 5.5, 6.5 | Multiple |
| Metal plate 7 | Copper | 10.0, 10.0 | Multiple |

Next, the brazing filler paste was applied onto the ceramic substrate and dried to form an application layer. The metal plate was disposed on the application layer to produce a stacked structure. The stacked structure was fixed with a jig and a load of 0.5 kPa or more was applied thereto to perform heat bonding in a vacuum (1 × 10⁻³ Pa or less). Table 3 shows whether the temperature holding stage is performed in the temperature increase stage, the bonding temperature, the holding temperature during the temperature decrease stage, and the load in each Example. In Comparative Example 1, the temperature holding stage was not provided in the temperature increase stage and the temperature decrease stage. The temperature holding stage in the temperature increase stage was performed at a temperature within a range of 400°C to 900°C and lower than the bonding temperature.

**[Table 3]**

| | Configuration of metal plate | | Brazing filler | Conditions of heat bonding | | |
|---|---|---|---|---|---|---|
| | Front metal plate | Back metal plate | | Holding stage (during temperature increase) | Bonding temperature [°C] | Holding temperature (during temperature decrease) [°C] |
| Example 1 | Metal plate 5 | Metal plate 3 | Brazing filler 3 | Performed | 850 | 750 |
| Example 2 | Metal plate 5 | None | Brazing filler 3 | Not performed | 850 | 750 |
| Example 3 | Metal plate 5 | Metal plate 1 | Brazing filler 3 | Performed | 850 | 750 |
| Example 4 | Metal plate 5 | Metal plate 2 | Brazing filler 3 | Not performed | 850 | 750 |
| Example 5 | Metal plate 5 | Metal plate 3 | Brazing filler 3 | Performed | 720 | 700 |
| Example 6 | Metal plate 5 | Metal plate 3 | Brazing filler 3 | Performed | 800 | 700 |
| Example 7 | Metal plate 5 | Metal plate 3 | Brazing filler 3 | Not performed | 930 | 780 |
| Example 8 | Metal plate 4 | Metal plate 1 | Brazing filler 1 | Performed | 850 | 750 |
| Example 9 | Metal plate 6 | Metal plate 2 | Brazing filler 2 | Performed | 850 | 750 |
| Example 10 | Metal plate 7 | Metal plate 3 | Brazing filler 3 | Performed | 850 | 750 |
| Example 11 | Example 5 | Metal plate 1 | Brazing filler 4 | Performed | 900 | 750 |
| Example 12 | Example 6 | Metal plate 2 | Brazing filler 4 | Performed | 900 | 700 |
| Comparative example 1 | Metal plate 5 | Metal plate 3 | Brazing filler 3 | Not performed | 850 | - |
| Comparative example 2 | Metal plate 5 | Metal plate 3 | Brazing filler 3 | Not performed | 670 | 500 |
| Comparative example 3 | Metal plate 5 | Metal plate 3 | Brazing filler 3 | Not performed | 960 | 820 |

In Examples 1, 3, 5, 6, and 8 to 12 and Comparative Example 1, the ratio of the volume [cm³] of the front metal plate to the volume [cm³] of the back metal plate is within a range of not less than 0.98 and not more than 1.02. In Example 2, no back metal plate is provided. In Examples 4 and 7 and Comparative Examples 2 and 3, the ratio of the volume [cm³] of the front metal plate to the volume [cm³] of the back metal plate is outside a range of not less than 0.98 and not more than 1.02. In all Examples and Comparative Examples, the difference between the maximum width L₁ and the minimum width L₂ was 100 µm or less (including zero). In Examples, the metal plates satisfied (L₁ - L₂)/0.2T < (L_{b} - Lₜ)/T.

For the ceramic circuit board according to each Example and each Comparative Example, any four longitudinal sections of the metal plate were prepared. Each longitudinal section was photographed at a six-fold magnification, and dimensions in the longitudinal section were measured from the photograph. The magnified photograph was used to measure the width Lₜ of the top side of the metal plate, the width L_{b} of the bottom side of the metal plate, the maximum width L₁ in the intermediate portion of the metal plate, the minimum width L₂ in the intermediate portion of the metal plate, the protruding amount W₁ in the bonding layer, and the rising amount W₂ in the bonding layer. As the thickness T of the metal plate, the thickness of the metal plate before the bonding was used.

The ratio L_{b}/Lₜ, the ratio L₁/L₂, and (L₁ - L₂)/0.4T were calculated from the obtained results. A longitudinal section having the largest ratio L_{b}/Lₜ was selected from among the four longitudinal sections. The ratio L_{b}/Lₜ, the ratio L₁/L₂, and (L₁ - L₂)/0.4T in the longitudinal section are shown in Table 4.

From the photograph of the longitudinal section from which the largest L_{b}/Lₜ was obtained, the protruding amount W₁ and the rising amount W₂ of the bonding layer were measured. The protruding amount and the rising amount were measured at both ends of the metal plate in one longitudinal section, and a larger protruding amount was taken as the protruding amount W₁ of the bonding layer, and a larger rising amount was taken as the rising amount W₂ of the bonding layer. Among the rising amounts measured at both ends, the larger rising amount was referred to as "maximum value W₂ₘₐₓ of the rising amount W₂", and the smaller rising amount was referred to as "minimum value W₂ₘᵢₙ of the rising amount W₂". The protruding amount W₁, the rising amount W₂, and the difference between the maximum value W₂ₘₐₓ and the minimum value W₂ₘᵢₙ of the rising amount W₂ are shown in Table 4.

**[Table 4]**

| | Metal plate | | | Bonding layer | | |
|---|---|---|---|---|---|---|
| | L_{b} / L₁ | L₁ / L₂ | (L₁ - L₂) /0.4T | W₁ [mm] | W₂ [mm] | W₂ₘₐₓ -W₂ₘᵢₙ [mm] |
| Example 1 | 1.026 | 1.005 | 0.038 | 0.5 | 1.5 | 0.6 |
| Example 2 | 1.021 | 1.006 | 0.032 | 0.8 | 1.5 | 0.7 |
| Example 3 | 1.015 | 1.010 | 0.040 | 0.3 | 1.8 | 0.9 |
| Example 4 | 1.010 | 1.003 | 0.032 | 0.3 | 1.4 | 0.7 |
| Example 5 | 1.023 | 1.008 | 0.035 | 0.4 | 1.7 | 0.9 |
| Example 6 | 1.016 | 1.003 | 0.035 | 0.6 | 1.9 | 0.7 |
| Example 7 | 1.018 | 1.009 | 0.041 | 0.5 | 1.5 | 0.6 |
| Example 8 | 1.025 | 1.003 | 0.036 | 0.8 | 1.4 | 0.5 |
| Example 9 | 1.012 | 1.005 | 0.034 | 0.6 | 1.4 | 1.0 |
| Example 10 | 1.019 | 1.006 | 0.031 | 0.3 | 1.5 | 0.7 |
| Example 11 | 1.007 | 1.001 | 0.029 | 0.4 | 1.1 | 0.4 |
| Example 12 | 1.010 | 1.002 | 0.026 | 0.3 | 1.2 | 0.6 |
| Comparative example 1 | 1.003 | 1.002 | 0.017 | 0.5 | 1.5 | 0.4 |
| Comparative example 2 | 1.004 | 1.001 | 0.017 | 0.4 | 1.5 | 0.6 |
| Comparative example 3 | 1.004 | 1.002 | 0.019 | 0.4 | 1.6 | 0.6 |

It can be seen from Table 4 that four conditions that the ratio L_{b}/Lₜ is not less than 1.005 and not more than 1.050, the ratio L₁/L₂ is not less than 1.0 and not more than 1.010, ratio L_{b}/Lₜ > ratio L₁/L₂ is satisfied, and width L_{b} > maximum width L₁ is satisfied are satisfied in Examples. Although Table 4 shows data of the part in which the ratio L_{b}/Lₜ is largest, the four conditions were also satisfied in the other three parts in Examples.

In contrast, in Comparative Examples, the ratio L_{b}/L₁ was less than 1.005. In Comparative Examples, the ratio L_{b}/L₁ was also out of the preferable range in the other three portions. That is, in Comparative Examples, the first portion was not formed in the metal plate.

Next, the thermal-cycle durability of the ceramic circuit board according to each Example and each Comparative Example was evaluated by a TCT. A TCT is a test in which a test product is placed in an environment in which the temperature sequentially changes to a low temperature and a high temperature to check, for example, resistance to the temperature changes. In the TCT, the test product is held at -40°C for 30 minutes, held at room temperature for 10 minutes, held at 175°C for 30 minutes, and held at room temperature for 10 minutes. This is assumed to be one cycle, and 500 cycles, 1000 cycles, and 5000 cycles were performed. Thereafter, the area in which cracking occurred between the ceramic substrate and the metal plate was determined by using an ultrasonic flaw detector, the soundness η of each ceramic circuit board was calculated in accordance with Expression (1) below, and the thermal-cycle durability of each silicon nitride circuit board was evaluated.$η = \left(1-Σd/D\right) \times 100 \left(%\right)$ (Expression 1)

In Math. 1, "D" is a value when the length of the perimeter of the bonded portion of the circuit board is assumed to be 100%. When a plurality of copper plates are bonded, "D" indicates the total of the lengths of the perimeters of the bonded portions. That is, "D" is the total length of the copper plate edge portion path in which cracking can occur. "Σd" is the sum of the lengths (d1, d2, ..., dn) of cracks generated in the path. In a case where the soundness η is 100%, it indicates that no cracks were observed. Example in which the soundness η is 100% is evaluated as "good", Example in which the soundness η is less than 100% and not less than 95% is evaluated as "fair", and Example in which the soundness η is less than 95% is evaluated as "poor". The results are shown in Table 5.

**[Table 5]**

| | Soundness after TCT | | |
|---|---|---|---|
| | 500 cycles | 1000 cycles | 5000 cycles |
| Example 1 | Good | Good | Good |
| Example 2 | Good | Good | Fair |
| Example 3 | Good | Good | Good |
| Example 4 | Good | Good | Fair |
| Example 5 | Good | Good | Good |
| Example 6 | Good | Good | Good |
| Example 7 | Good | Good | Fair |
| Example 8 | Good | Good | Good |
| Example 9 | Good | Good | Good |
| Example 10 | Good | Good | Good |
| Example 11 | Good | Good | Good |
| Example 12 | Good | Good | Good |
| Comparative example 1 | Good | Fair | Poor |
| Comparative example 2 | Good | Good | Poor |
| Comparative example 3 | Fair | Fair | Poor |

It can be seen from Table 5 that in a case where the number of cycles is small, there is no large difference in soundness η between Examples and Comparative Examples. However, in a case of the number of cycles of 5000, cracking occurred in all Comparative Examples, and the soundness η fell below 95%. This is considered to be because the first portion is formed in the metal plate in Examples. Since the metal plate includes the first portion, thermal stress applied to the ceramic substrate at the time of temperature change can be reduced compared to the metal plate without the first portion. As a result, it is considered that excellent thermal-cycle durability was attained in Examples compared to Comparative Examples.

More specifically, in Examples 2, 4, and 7 in Table 5, the thermal-cycle durability was degraded in 5000 cycles compared to the other Examples. In Example 2, this is considered to be because no back metal plate is provided. In Examples 4 and 7, this is considered to be because the ratio of the volume [cm³] of the front metal plate to the volume [cm³] of the back metal plate is outside a range of not less than 0.98 and not more than 1.02. From these results, it is found to be preferable to bond metal plates to both faces of the ceramic substrate. It is also found to be preferable that the ratio of the volume [cm³] of the front metal plate to the volume [cm³] of the back metal plate be within a range of not less than 0.98 and not more than 1.02.

For the ceramic circuit boards according to Examples, position detection was performed using a CCD camera. In the position detection, the ceramic circuit boards were photographed with the CCD camera from the Z-direction, and images were obtained. The outer peripheral end portion of the top face of the copper plate was detected from the obtained images. In all Examples, the position of the outer peripheral end portion detected in the position detection was within a range of 0.1 mm from the actual outer peripheral end portion of the top face of the copper plate, which showed excellent position detection accuracy. This is because the copper plate includes the second portion 6 in the ceramic circuit boards according to Examples. As the side face of the upper portion of the copper plate is more perpendicular, the outer peripheral end portion of the top face of the copper plate is more likely to be detected.

Embodiments of the invention include the following features.

### (Feature 1)

A ceramic circuit board including:
a ceramic substrate having a first face; and
a first metal plate bonded to the first face with a first bonding layer interposed,
the first metal plate satisfying conditions in any cross section perpendicular to the first face, the conditions being such that
   a ratio L_{b}/Lₜ between a width L_{b} [mm] of a bottom side and a width Lₜ [mm] of a top side is not less than 1.005 and not more than 1.050,
   a ratio L₁/L₂ between a maximum width L₁ [mm] and a minimum width L₂ [mm] in an intermediate portion located between the bottom side and a distance 0.4 to 0.6 times a thickness T of the metal plate is not less than 1.0 and not more than 1.010,
   the ratio L_{b}/Lₜ is larger than the ratio L₁/L₂, and
   the width L_{b} is longer than the minimum width L₁.

### (Feature 2)

The ceramic circuit board according to Feature 1, in which a plurality of the first metal plates are bonded to the first face.

### (Feature 3)

The ceramic circuit board according to Feature 1, in which
a plurality of the first metal plates are bonded to the first face, and
a shortest distance between adjacent first metal plates among the plurality of first metal plates is 10 mm or less.

### (Feature 4)

The ceramic circuit board according to Feature 1, further including:
a second metal plate bonded to a second face of the ceramic with a second bonding layer interposed, the second face being opposite to the first face,
one or more of the first metal plates being bonded to the first face,
one or more of the second metal plates being bonded to the second face,
the thickness T of each of the one or more first metal plates being not less than 0.5 mm and not more than 10 mm,
a ratio between a total volume of the one or more first metal plates and a total volume of the one or more second metal plates being not less than 0.98 and not more than 1.02.

### (Feature 5)

The ceramic circuit board according to Feature 2 or 3, further including:
a second metal plate bonded to a second face of the ceramic with a second bonding layer interposed, the second face being opposite to the first face,
one or more of the second metal plates being bonded to the second face,
the thickness T of each of the plurality of first metal plates being not less than 0.5 mm and not more than 10 mm,
a ratio between a total volume of the plurality of first metal plates and a total volume of the one or more second metal plates being not less than 0.98 and not more than 1.02.

### (Feature 6)

The ceramic circuit board according to any one of Features 2 to 5, in which
a difference in thickness between the plurality of first metal plates is not less than 0 mm and not more than 3.0 mm, and
the thickness T of each of the plurality of first metal plates is not less than 1.0 mm and not more than 6.0 mm.

### (Feature 7)

The ceramic circuit board according to any one of Features 1 to 6, in which
the first bonding layer includes
a first region provided between the first face and the first metal plate,
a second region provided around the first region along the first face and protruding outside the first metal plate, and
a third region located on the second region and provided on a side face of the metal plate.

### (Feature 8)

The ceramic circuit board according to Feature 7, in which
a length of the second region in a direction from the first region toward the second region is 0.05 mm or more, and
a length of the third region in a first direction perpendicular to the first face is 0.1 mm or more.

### (Feature 9)

The ceramic circuit board according to any one of Features 1 to 8, in which the ceramic substrate is a silicon nitride substrate.

### (Feature 10)

The ceramic circuit board according to any one of Features 1 to 9, in which the first metal plate is a copper plate.

### (Feature 11)

A manufacturing method for a ceramic circuit board, including:
forming a brazing filler layer on a first face of a ceramic substrate, the brazing filler layer including an active metal brazing filler;
disposing a metal plate on the brazing filler layer; and
bonding the ceramic substrate and the metal plate together by heating,
the first metal plate of the manufactured ceramic circuit board satisfying conditions in any cross section perpendicular to the first face, the conditions being such that
   a ratio L_{b}/Lₜ between a width L_{b} [mm] of a bottom side and a width Lₜ [mm] of a top side is not less than 1.005 and not more than 1.050,
   a ratio L₁/L₂ between a maximum width L₁ [mm] and a minimum width L₂ [mm] in an intermediate portion located between the bottom side and a distance 0.4 to 0.6 times a thickness T of the metal plate is not less than 1.0 and not more than 1.010,
   the ratio L_{b}/Lₜ is larger than the ratio L₁/L₂, and
   the width L_{b} is longer than the minimum width L₁.

### (Feature 12)

The manufacturing method according to Feature 11, in which
a bonding temperature in the bonding is not less than 700°C and not more than 950°C, and
during a temperature decrease after the bonding, a temperature of the ceramic circuit board is maintained at a temperature lower than the bonding temperature by not less than 10°C and not more than 150°C.

### (Feature 13)

The manufacturing method according to Feature 11 or 12, in which
the thickness T of the metal plate is 0.5 mm or more, and
the ceramic substrate is a silicon nitride substrate.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

### [Reference Numeral List]

1 ceramic circuit board
2 ceramic substrate
2a first face
2b second face
3, 3a, 3b metal plate
4, 4a, 4b bonding layer
5 first portion
6 second portion
T thickness of metal plate
Lₜ width of top side of metal plate
L_{b} width of bottom side of metal plate
L₁ maximum width in intermediate portion of metal plate
L₂ minimum width in intermediate portion of metal plate
r1 first region
r2 second region
r3 third region
W₁ protruding amount in bonding layer
W₂ rising amount in bonding layer

## Claims

1. A ceramic circuit board comprising:
a ceramic substrate having a first face; and
a first metal plate bonded to the first face with a first bonding layer interposed,
the first metal plate satisfying conditions in any cross section perpendicular to the first face, the conditions being such that
a ratio L_{b}/Lₜ between a width L_{b} [mm] of a bottom side and a width Lₜ [mm] of a top side is not less than 1.005 and not more than 1.050,
a ratio L₁/L₂ between a maximum width L₁ [mm] and a minimum width L₂ [mm] in an intermediate portion located between the bottom side and a distance 0.4 to 0.6 times a thickness T of the metal plate is not less than 1.0 and not more than 1.010,
the ratio L_{b}/Lₜ is larger than the ratio L₁/L₂, and
the width L_{b} is longer than the minimum width L₁.

2. The ceramic circuit board according to claim 1, wherein a plurality of the first metal plates are bonded to the first face.

3. The ceramic circuit board according to claim 1, wherein
a plurality of the first metal plates are bonded to the first face, and
a shortest distance between adjacent first metal plates among the plurality of first metal plates is 10 mm or less.

4. The ceramic circuit board according to claim 1, further comprising:
a second metal plate bonded to a second face of the ceramic with a second bonding layer interposed, the second face being opposite to the first face,
one or more of the first metal plates being bonded to the first face,
one or more of the second metal plates being bonded to the second face,
the thickness T of each of the one or more first metal plates being not less than 0.5 mm and not more than 10 mm,
a ratio between a total volume of the one or more first metal plates and a total volume of the one or more second metal plates being not less than 0.98 and not more than 1.02.

5. The ceramic circuit board according to claim 2 or 3, further comprising:
a second metal plate bonded to a second face of the ceramic with a second bonding layer interposed, the second face being opposite to the first face,
one or more of the second metal plates being bonded to the second face,
the thickness T of each of the plurality of first metal plates being not less than 0.5 mm and not more than 10 mm,
a ratio between a total volume of the plurality of first metal plates and a total volume of the one or more second metal plates being not less than 0.98 and not more than 1.02.

6. The ceramic circuit board according to any one of claims 2 to 5, wherein
a difference in thickness between the plurality of first metal plates is not less than 0 mm and not more than 3.0 mm, and
the thickness T of each of the plurality of first metal plates is not less than 1.0 mm and not more than 6.0 mm.

7. The ceramic circuit board according to any one of claims 1 to 6, wherein
the first bonding layer includes
a first region provided between the first face and the first metal plate,
a second region provided around the first region along the first face and protruding outside the first metal plate, and
a third region located on the second region and provided on a side face of the metal plate.

8. The ceramic circuit board according to claim 7, wherein
a length of the second region in a direction from the first region toward the second region is 0.05 mm or more, and
a length of the third region in a first direction perpendicular to the first face is 0.1 mm or more.

9. The ceramic circuit board according to any one of claims 1 to 8, wherein the ceramic substrate is a silicon nitride substrate.

10. The ceramic circuit board according to any one of claims 1 to 9, wherein the first metal plate is a copper plate.

11. A manufacturing method for a ceramic circuit board, comprising:
forming a brazing filler layer on a first face of a ceramic substrate, the brazing filler layer including an active metal brazing filler;
disposing a metal plate on the brazing filler layer; and
bonding the ceramic substrate and the metal plate together by heating,
the first metal plate of the manufactured ceramic circuit board satisfying conditions in any cross section perpendicular to the first face, the conditions being such that
a ratio L_{b}/Lₜ between a width L_{b} [mm] of a bottom side and a width Lₜ [mm] of a top side is not less than 1.005 and not more than 1.050,
a ratio L₁/L₂ between a maximum width L₁ [mm] and a minimum width L₂ [mm] in an intermediate portion located between the bottom side and a distance 0.4 to 0.6 times a thickness T of the metal plate is not less than 1.0 and not more than 1.010,
the ratio L_{b}/Lₜ is larger than the ratio L₁/L₂, and
the width L_{b} is longer than the minimum width L₁.

12. The manufacturing method according to claim 11, wherein
a bonding temperature in the bonding is not less than 700°C and not more than 950°C, and
during a temperature decrease after the bonding, a temperature of the ceramic circuit board is maintained at a temperature lower than the bonding temperature by not less than 10°C and not more than 150°C.

13. The manufacturing method according to claim 11 or 12, wherein
the thickness T of the metal plate is 0.5 mm or more, and
the ceramic substrate is a silicon nitride substrate.
